(19) Europäisches Patentamt
European Patent Office
Office européen des brevets

(11) **EP 2 884 495 B1**

(12) **FASCICULE DE BREVET EUROPEEN**

(45) Date de publication et mention de la délivrance du brevet:
**26.07.2017 Bulletin 2017/30**

(51) Int Cl.:
*G11C 13/00* [(2006.01)]   *G11C 7/10* [(2006.01)]

(21) Numéro de dépôt: **14195934.6**

(22) Date de dépôt: **02.12.2014**

(54) **Procédé de détermination de paramètres électriques servant à programmer une mémoire vive résistive**

Verfahren zur Bestimmung der elektrischen Parameter, die zum Programmieren eines resistiven Arbeitsspeichers dienen

Method for determining electrical parameters for programming a resistive random access memory

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **11.12.2013 FR 1362421**

(43) Date de publication de la demande:
**17.06.2015 Bulletin 2015/25**

(73) Titulaire: **COMMISSARIAT À L'ÉNERGIE ATOMIQUE ET AUX ÉNERGIES ALTERNATIVES**
**75015 Paris (FR)**

(72) Inventeurs:
• **Molas, Gabriel**
**38000 GRENOBLE (FR)**
• **Guy, Jérémy**
**38000 GRENOBLE (FR)**

(74) Mandataire: **Cabinet Camus Lebkiri**
**25 rue de Maubeuge**
**75009 Paris (FR)**

(56) Documents cités:
**US-A1- 2005 243 633   US-A1- 2012 201 069**
**US-A1- 2013 250 657**

• **VIANELLO E ET AL: "On the impact of Ag doping on performance and reliability of GeS 2 -based Conductive Bridge Memories", SOLID-STATE DEVICE RESEARCH CONFERENCE (ESSDERC), 2012 PROCEEDINGS OF THE EUROPEAN, IEEE, 17 septembre 2012 (2012-09-17), pages 278-281, XP032466618, DOI: 10.1109/ESSDERC.2012.6343387 ISBN: 978-1-4673-1707-8**

• **IELMINI D ET AL: "Trade-off between data retention and reset in NiO RRAMS", RELIABILITY PHYSICS SYMPOSIUM (IRPS), 2010 IEEE INTERNATIONAL, IEEE, PISCATAWAY, NJ, USA, 2 mai 2010 (2010-05-02), pages 620-626, XP031692268, ISBN: 978-1-4244-5430-3**

**Description**

**DOMAINE TECHNIQUE**

La présente invention concerne le domaine des mémoires réinscriptibles non volatiles, et plus spécifiquement celui des mémoires vives résistives. Une mémoire vive résistive comprend des première et seconde électrodes séparées par une couche en matériau électriquement isolant, et passe d'un état isolant à un état conducteur par formation d'un filament conducteur entre les première et seconde électrodes.

**ETAT DE LA TECHNIQUE**

Les mémoires vives à résistance variable (appelées mémoires RRAM pour « Resistive Random Access Memories » en anglais) sont aujourd'hui le sujet d'une grande attention, en raison notamment de leur faible consommation électrique et leur vitesse de fonctionnement élevée.

Une cellule mémoire de type résistive présente au moins deux états : un état fortement résistif « HRS » (« High Resistance State »), appelé également état « OFF », et un état faiblement résistif « LRS » (« Low Resistance State ») ou état « ON ». Elle peut donc être utilisée pour stocker une information binaire.

On peut distinguer trois types de mémoires résistives : les mémoires à base de mécanisme thermochimique, les mémoires à base de changement de valence, et les mémoires à base de métallisation électrochimique.

Le domaine de la présente invention concerne plus particulièrement cette dernière catégorie basée sur des matériaux à conduction ionique (mémoires CBRAM ou « Conductive Bridging RAM »). Le fonctionnement réside dans la formation et la rupture réversibles d'un filament conducteur dans un électrolyte solide, par dissolution d'une électrode soluble. Ces mémoires sont prometteuses de par leur faibles tensions de programmation (de l'ordre du Volt), leur temps de programmation court (<1 $\mu$s), leur faible consommation et leur faible coût d'intégration. De plus, ces mémoires peuvent être intégrées dans les niveaux de métallisation de la logique d'un circuit (« above IC »), ce qui permet d'augmenter la densité d'intégration du circuit. Du point de vue de l'architecture, elles requièrent seulement un dispositif de sélection, un transistor ou une diode par exemple.

Le fonctionnement des mémoires CBRAM est basé sur la formation, au sein d'un électrolyte solide, d'un ou plusieurs filaments métalliques (appelés également « dendrites ») entre deux électrodes, lorsque ces électrodes sont portées à des potentiels appropriés. La formation du filament permet d'obtenir une conduction électrique donnée entre les deux électrodes. En modifiant les potentiels appliqués aux électrodes, il est possible de modifier la répartition du filament, et de modifier ainsi la conduction électrique entre les deux électrodes. Par exemple, en inversant le potentiel entre les électrodes, il est possible de faire disparaître ou de réduire le filament métallique, de manière à supprimer ou à réduire considérablement la conduction électrique due à la présence du filament.

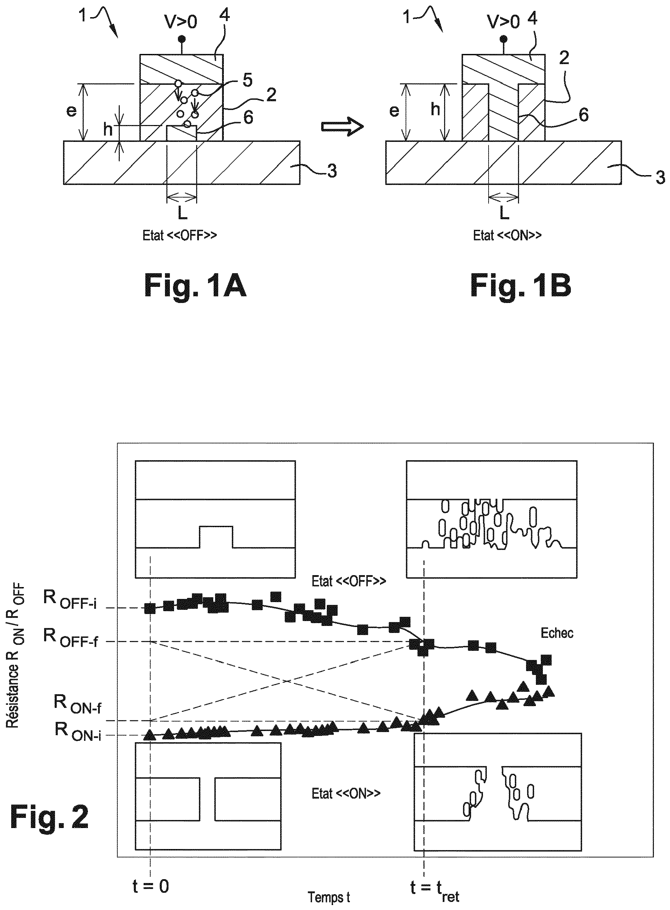

Les figures 1A et 1B sont des schémas de principe d'un dispositif mémoire 1 de type CBRAM, respectivement à l'état « OFF » et à l'état « ON ».

Ce dispositif 1 est formé par un empilement de type Métal/Conducteur ionique/Métal. Il comporte un électrolyte solide 2, par exemple à base de chalcogénure dopé (ex. GeS) ou d'oxyde (ex. $Al_2O_3$). L'électrolyte 2 est disposé entre une électrode inférieure 3, par exemple en Pt, formant une cathode inerte, et une électrode supérieure 4 comportant une portion de métal ionisable, par exemple du cuivre, et formant une anode. Une portion de métal ionisable est une portion de métal pouvant former des ions métalliques (ici des ions $Cu^{2+}$), lorsqu'elle est soumise à un potentiel électrique approprié. Le dispositif 1 représenté sur la figure 1A ou 1B forme typiquement un point mémoire, c'est-à-dire une cellule mémoire unitaire, d'une mémoire comportant une multitude de ces dispositifs mémoires.

Comme indiqué précédemment, l'état mémoire d'un dispositif mémoire CBRAM résulte de la différence de résistivité électrique entre deux états : « ON » et « OFF ».

A l'état « OFF » (Fig.1A), les ions métalliques (ici les ions $Cu^{2+}$ pour une électrode soluble comprenant du Cu) issus de la portion de métal ionisable sont dispersés dans tout l'électrolyte solide 2. Ainsi, aucun contact électrique n'est établi entre la cathode 3 et l'anode 4, c'est-à-dire entre l'électrode supérieure et l'électrode inférieure. L'électrolyte solide comporte une zone électriquement isolante de grande résistivité entre l'anode et la cathode.

Lorsqu'un potentiel V positif est appliqué sur l'électrode soluble supérieure 4 (l'anode), une réaction d'oxydoréduction a lieu à cette électrode, créant des ions mobiles 5 (Fig.1A). Dans le cas d'une électrode 4 de cuivre, la réaction suivante a lieu :

$$Cu \rightarrow Cu^{2+} + 2\ e^-.$$

Les ions 5 se déplacent alors dans l'électrolyte 2 sous l'effet du champ électrique appliqué aux électrodes. La vitesse de déplacement dépend de la mobilité de l'ion dans l'électrolyte en question, ce qui guide le choix du couple électrode soluble/électrolyte (exemples : Ag/GeS ; $Cu/Al_2O_3$...). Les vitesses de déplacement des ions sont de l'ordre du nm/ns.

Arrivés à l'électrode inerte 3 (la cathode), les ions 5 sont réduits de par la présence d'électrons fournis par l'électrode 3, entraînant la croissance d'un filament métallique 6 selon la réaction suivante :

$$Cu^{2+} + 2\ e^- \rightarrow Cu$$

Le filament 6 croît préférentiellement dans la direction de l'électrode soluble 4.

La mémoire 1 passe alors dans l'état « ON » (Fig.1B) lorsque le filament 6 permet le contact entre les électrodes 3 et 4, rendant l'empilement conducteur. Cette phase est appelé « SET » de la mémoire.

Pour passer à l'état « OFF » (phase de « RESET » de la mémoire), une tension V négative est appliquée sur l'électrode supérieure 4, entrainant la dissolution du filament conducteur. Pour justifier cette dissolution, des mécanismes thermiques (échauffement) et d'oxydoréduction sont généralement invoqués.

Souvent, l'électrolyte 2 contient dans l'état « OFF » un filament résiduel 6 en contact avec la cathode 3. Celui-ci provient de la phase de SET précédente et n'a pas été dissous complétement lors du RESET de la mémoire. Le filament est dit résiduel lorsqu'il n'établit pas une conduction électrique suffisante entre les électrodes pour obtenir l'état « ON ».

De nombreuses études portent sur ces mémoires CBRAM pour améliorer leurs performances électriques. Parmi les solutions proposées, on peut notamment citer l'ingénierie de l'électrolyte (ajout de dopants, choix de nouveaux matériaux, recuits, traitements UV...), l'ingénierie de l'électrode soluble et de l'électrode inerte ou l'ajout d'interface(s) entre les électrodes et l'électrolyte.

Une autre voie de développement concerne la rétention de l'information, c'est-à-dire la rétention de l'état « OFF » et de l'état « ON ». On cherche à améliorer la stabilité des états isolant et conducteur, notamment pour des températures de fonctionnement élevées.

A cet égard, le document US2012/201069 décrit une mémoire vive résistive de type CBRAM dont la rétention de l'information est améliorée en appliquant successivement des conditions de programmation fortes et des conditions de programmation faibles. Ce mode de programmation découle de l'observation du fait que la rétention d'un état conducteur ou isolant dépend des conditions d'écriture ou d'effacement précédemment appliquées.

Le document [« On the impact of Ag doping on performance and reliability of GeS2-based Conductive Bridge Memories » ; E. Vianello et al., Solid-State Device Research Conference (ESSDERC), 2012 Proceedings of the European, pp. 278-281, 2012] montre que la rétention de l'état conducteur dans une mémoire vive résistive CBRAM varie en fonction de la teneur en argent de l'électrode active et de la résistance initiale de la mémoire à l'état conducteur. Connaissant cette résistance initiale, il est possible de déterminer une durée avant défaillance de la mémoire, c'est-à-dire la durée après laquelle la résistance à l'état conducteur est 10 fois plus grande que la résistance initiale.

Enfin, le document US2005/243633 décrit une mémoire PMC (« Programmable Metallization Cell ») programmée pour conserver l'information pendant une période de temps limitée. Ce document montre le lien entre l'évolution de la résistance à l'état conducteur après une opération d'écriture et les différentes conditions de programmation, et par conséquent, différentes tailles de filament conducteur. A l'aide d'une table de correspondance, il est possible de déterminer quelle condition d'écriture appliquer pour atteindre la durée de rétention souhaitée.

## RESUME DE L'INVENTION

L'invention vise à garantir la stabilité des états conducteur et isolant d'une mémoire vive résistive, pendant une durée de rétention donnée.

On tend à remplir cet objectif en choisissant des valeurs particulières de paramètres électriques pour programmer la mémoire vive résistive dans son état isolant et dans son état conducteur.

L'invention concerne un procédé de détermination de ces paramètres de programmation, comprenant les étapes suivantes :

- fournir un jeu de paramètres comprenant une durée de rétention cible des états isolant et conducteur, une valeur maximale de résistance à l'état conducteur et une valeur minimale de résistance à l'état isolant ;
- simuler des courbes de rétention de l'état conducteur correspondant à différentes dimensions de filament, chaque courbe de rétention de l'état conducteur représentant l'augmentation de la résistance à l'état conducteur en fonction d'un temps de rétention ;
- déterminer la courbe de rétention de l'état conducteur atteignant la valeur maximale de résistance à l'état conducteur après un temps de rétention égal à la durée de rétention cible ;
- déterminer une valeur initiale de résistance à l'état conducteur à partir de ladite courbe de rétention de l'état conducteur ;
- déterminer le paramètre de programmation de l'état conducteur à partir de la valeur initiale de résistance à l'état conducteur ;

- simuler des courbes de rétention de l'état isolant correspondant à différentes dimensions de filament, chaque courbe de rétention de l'état isolant représentant la diminution de la résistance à l'état isolant en fonction du temps de rétention ;
- déterminer la courbe de rétention de l'état isolant atteignant la valeur minimale de résistance à l'état isolant après un temps de rétention égal à la durée de rétention cible ;
- déterminer une valeur initiale de résistance à l'état isolant à partir de ladite courbe de rétention de l'état isolant ; et
- déterminer le paramètre de programmation de l'état isolant à partir de la valeur initiale de résistance à l'état isolant.

Dans un mode de mise en oeuvre préférentiel, les courbes de rétention de l'état conducteur correspondent à différentes largeurs initiales de filament, le filament ayant une hauteur initiale égale à l'épaisseur de la couche en matériau électriquement isolant.

Le procédé comporte alors avantageusement une étape de détermination d'une largeur de filament optimale correspondant à ladite courbe de rétention de l'état conducteur et les courbes de rétention de l'état isolant peuvent être simulées pour un filament ayant une largeur initiale égale à la largeur optimale et une hauteur initiale variable.

De préférence, les courbes de rétention de l'état conducteur et de l'état isolant sont obtenues en effectuant, pour différents temps de rétention, les étapes suivantes :

- simuler une diffusion des atomes formant le filament ;
- calculer la concentration en atomes dans différentes portions de la couche en matériau électriquement isolant ;
- calculer, à partir de la concentration en atomes, la résistivité électrique équivalente dans chaque portion ; et
- calculer une résistance globale de la mémoire à partir des résistivités électriques équivalentes des différentes portions de la couche en matériau électriquement isolant.

Le procédé selon l'invention peut également présenter une ou plusieurs des caractéristiques ci-dessous, considérées individuellement ou selon toutes les combinaisons techniquement possibles :

- la valeur initiale de résistance à l'état conducteur est obtenue en relevant l'ordonnée à l'origine de ladite courbe de rétention de l'état conducteur ;
- la valeur initiale de résistance à l'état isolant est obtenue en relevant l'ordonnée à l'origine de ladite courbe de rétention de l'état isolant ; et
- la première électrode est en un matériau inerte, la deuxième électrode est en un matériau soluble et le matériau électriquement isolant est un matériau conducteur ionique, le filament conducteur étant formé par des atomes du matériau de l'électrode soluble.

Un autre aspect de l'invention concerne un programme d'ordinateur comportant des moyens pour la mise en oeuvre du procédé.

## BREVES DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :

- Les figure 1A et 1B représentent une cellule mémoire CBRAM respectivement à l'état « OFF » et à l'état « ON » ;
- la figure 2 représente une courbe de rétention de l'état « ON » et une courbe de rétention de l'état « OFF », ainsi que les formes de filament correspondantes dans chaque état ;
- la figure 3 représente des étapes F1 à F9 d'un procédé selon l'invention, permettant de déterminer les paramètres de programmation d'une mémoire résistive ;
- la figure 4 représente des courbes de rétention de l'état « ON » obtenues à l'étape F2 du procédé de la figure 3 ;
- la figure 5 est un abaque $R_{ON}(I_{SET})$ pouvant être utilisé à l'étape F5 du procédé de la figure 3 ;
- la figure 6 est un abaque $R_{OFF}(V_{RST})$ pouvant être utilisé à l'étape F9 du procédé de la figure 3 ;
- les figures 7A et 7B représentent à deux instants $t_0$ et $t_1$ la répartition des atomes d'un filament métallique dans une couche d'électrolyte de la mémoire résistive ;
- la figure 7C représente la concentration des atomes du filament métallique dans la couche d'électrolyte de la figure 7B ;
- la figure 7D représente un réseau de résistances électriques équivalent à la répartition d'atomes de la figure 7B ;
- la figure 8 représente deux courbes de rétention de l'état « ON » d'une mémoire résistive à une première température ; et

- la figure 9 représente un ensemble de courbes iso-pentes, en fonction du coefficient de diffusion D et de l'inverse de la largeur du filament 1/L.

Pour plus de clarté, les éléments identiques ou similaires sont repérés par des signes de références identiques sur l'ensemble des figures.

## DESCRIPTION DETAILLEE D'AU MOINS UN MODE DE REALISATION

Dans la description qui suit, on prend l'exemple d'une cellule mémoire résistive CBRAM 1 telle que décrite précédemment aux figures 1A et 1B. La mémoire 1 comprend une couche d'électrolyte solide 2 en un matériau conducteur ionique et électriquement isolant, une première électrode 3 en un matériau inerte (la cathode) et une deuxième électrode 4 en un matériau soluble (l'anode). La couche d'électrolyte 2, d'épaisseur e, est disposée entre les électrodes 3 et 4.

La mémoire passe d'un état isolant « OFF » (ou fortement résistif HRS) (Fig.1A) à un état conducteur « ON » (ou faiblement résistif LRS) (Fig.1 B), par formation d'un filament conducteur 6 entre les électrodes 3 et 4. Le filament 6 croît préférentiellement dans la direction de l'électrode soluble 4. Il est formé par des ions du matériau de l'électrode soluble 4, de préférence un métal, qui diffusent dans l'électrolyte 2 sous l'action de potentiels électriques appliqués aux électrodes. Inversement, elle passe de l'état « ON » à l'état « OFF », lorsque le filament métallique 6 est dissous dans l'électrolyte 2.

Le filament 6 peut avoir différentes formes (parallélépipédique, cylindrique...), en fonction notamment des formes et dimensions de la couche d'électrolyte 2 et des électrodes 3 et 4. Vu en coupe sur les figures 1A et 1B, le filament 6 a la forme d'un rectangle. On appelle ci-après « hauteur » la dimension h du filament (visible sur les figures 1A et 1B) selon une direction perpendiculaire aux plans des électrodes 3 et 4. La « largeur » désigne la dimension L du filament selon une direction parallèle aux plans des électrodes et contenue dans le plan de coupe des figures 1A et 1B. Lorsque le filament a globalement la forme d'un cylindre, la largeur L correspond en fait au diamètre du cylindre.

La rétention de l'état « OFF » ou « ON » d'une mémoire résistive peut être représentée en traçant l'évolution de la résistance de la mémoire dans cet état, en fonction du temps.

La figure 2 donne un exemple de courbe de rétention de l'état « ON » (courbe inférieure $R_{ON}(t)$) et un exemple de courbe de rétention de l'état « OFF » (courbe supérieure $R_{OFF}(t)$), pour une mémoire de type CBRAM.

A l'état initial (t=0), c'est-à-dire immédiatement après avoir formé le filament conducteur, la résistance $R_{ON}$ de la mémoire à l'état « ON » est minimale. Cette valeur initiale est notée $R_{ON-i}$. Puis, au fil du temps, la résistance à l'état « ON » augmente pour atteindre un premier seuil de résistance $R_{ON-f}$ après une certaine durée de rétention $t_{ret}$. A partir de ce seuil, on considère que la conduction électrique assurée par le filament n'est plus satisfaisante et que la mémoire est dans un état d'échec. Autrement dit, l'état « ON » se dégrade progressivement et prend fin à $t=t_{ret}$.

A l'inverse, la résistance à l'état « OFF », notée $R_{OFF}$, est au départ maximale ($R_{OFF-i}$), puis diminue progressivement. L'état « OFF » s'affaiblit jusqu'à un deuxième seuil de résistance $R_{OFF-f}$, également défini pour un temps t égal à la durée de rétention $t_{ret}$.

Ainsi, les états isolant et conducteur de la mémoire peuvent être définis par des seuils de résistance. L'état isolant « OFF » correspond à une résistance de la mémoire supérieure au seuil de résistance $R_{OFF-f}$, tandis que l'état conducteur « ON » correspond à une résistance inférieure au seuil de résistance $R_{ON-f}$.

Entre les seuils $R_{OFF-f}$ et $R_{ON-f}$, c'est-à-dire pour une résistance inférieure au seuil $R_{OFF-f}$ et supérieure au seuil $R_{ON-f}$, il n'est plus possible de distinguer l'état de la mémoire. Par conséquent, l'information qu'elle contenait est perdue. Les seuils $R_{ON-f}$ et $R_{OFF-f}$ définissent ainsi une fenêtre mémoire résiduelle, représentée en traits pointillés sur la figure 2, pour une durée de rétention donnée ($t_{ret}$). A chaque instant pendant la durée de rétention, la cellule mémoire doit avoir une résistance (notée $R_{ON}$ ou $R_{OFF}$ selon son état) en dehors de cette fenêtre pour garantir l'intégrité des données qui y sont enregistrées.

A titre d'illustration, on a représenté à côté des courbes de la figure 2 la forme du filament dans chacun des états « ON » et « OFF », à t=0 et après une durée de rétention $t_{ret}$ ($t=t_{ret}$).

A l'instant t=0, le filament dans l'état « ON » connecte les deux électrodes. Sa hauteur est égale à l'épaisseur de l'électrolyte, c'est-à-dire à la distance séparant les électrodes. A l'instant $t=t_{ret}$, le filament s'est dispersé dans l'électrolyte, principalement à cause de la diffusion latérale (i.e dans une direction parallèle aux plans des électrodes) des atomes constituant le filament, ce qui explique une résistance plus importante.

De même, le filament résiduel dans l'état « OFF » est bien délimité à t=0. Sa hauteur est largement inférieure à l'épaisseur de l'électrolyte, de sorte qu'une portion isolante d'électrolyte sépare les deux électrodes. Puis, les atomes du métal formant le filament résiduel diffusent, latéralement et en direction de l'électrode supérieure. Il en résulte qu'à $t=t_{ret}$, la portion d'électrolyte séparant le filament résiduel initial de l'électrode supérieure s'est partiellement remplie de métal. Elle est, par conséquent, devenue moins isolante.

La stabilité des états conducteur et isolant, c'est-à-dire la pente des courbes de la figure 2, dépend de la forme initiale du filament conducteur (dans l'état conducteur) et du filament résiduel (dans l'état isolant). En effet, on a constaté que plus la largeur du filament conducteur est grande, plus la résistance à l'état « ON » $R_{ON}$ est faible et plus cet état est stable. En outre, plus la hauteur du filament résiduel dans l'électrolyte est faible, plus la résistance à l'état isolant $R_{OFF}$ est importante et plus l'état isolant est stable.

Partant de ce constat, on peut déterminer les formes initiales du filament conducteur et du filament résiduel qui garantissent la rétention des états conducteur et isolant pendant une durée de rétention « cible ». La durée de rétention cible est, en général, exprimée pour une certaine température de fonctionnement. Elle est, par exemple, de 10 ans (pour la plupart des applications mémoire non volatiles) à une température de 85 °C ou de 150 °C.

Par ailleurs, on sait que la forme du filament est déterminée par les conditions de programmation de la mémoire dans l'état « ON » et l'état « OFF ». Par exemple, plus le courant d'écriture $I_{SET}$ est important, plus le filament conducteur reliant les électrodes est large. En outre, plus la tension d'effacement est grande, plus le filament résiduel est bas. Il a donc été mis en oeuvre un procédé qui détermine ces conditions de programmation, connaissant la fenêtre mémoire résiduelle voulue par le fabriquant, c'est-à-dire les seuils de résistance à ne pas dépasser et la durée de rétention cible.

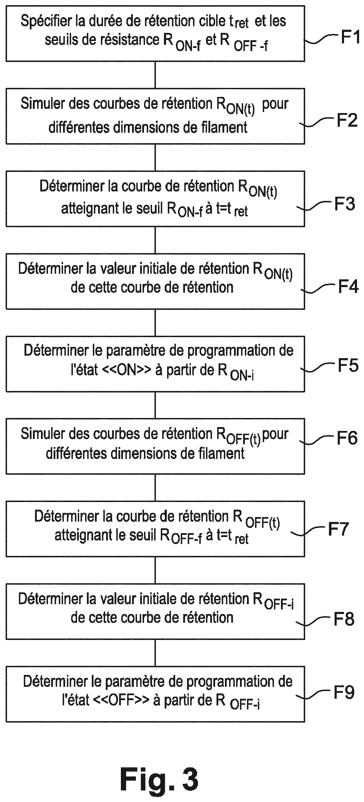

La figure 3 est un schéma synoptique représentant les différentes étapes F1 à F9 d'un tel procédé de détermination.

L'utilisateur définit lors d'une première étape F1 le jeu de paramètres qui servira de base à la détermination des conditions de programmation. Ce jeu de paramètres inclut la durée de rétention cible $t_{ret}$ des états isolant et conducteur, le premier seuil de résistance à l'état conducteur $R_{ON-f}$ et le deuxième seuil $R_{OFF-f}$ de résistance à l'état isolant.

Comme indiqué précédemment, le seuil $R_{ON-f}$ correspond à une valeur maximale de résistance de l'état « ON » et le seuil $R_{OFF-f}$ correspond à une valeur minimale de résistance de l'état « OFF ».

A l'étape F2, des simulations de rétention de l'état « ON » sont réalisées, en faisant varier une dimension du filament conducteur. Ainsi, une pluralité de courbes de rétention, correspondant à différentes dimensions de filament, est obtenue. Chaque courbe de rétention représente, comme dans l'exemple de la figure 2, l'augmentation de la résistance $R_{ON}$ en fonction d'un temps de rétention t. Cette augmentation de la résistance traduit la dispersion du filament métallique dans l'électrolyte au cours du temps.

De préférence, les courbes de rétention $R_{ON}(t)$ simulées à l'étape F2 correspondent à différentes largeurs initiales L de filament. La hauteur initiale h du filament est au contraire constante entre les simulations et égale à l'épaisseur e de la couche d'électrolyte.

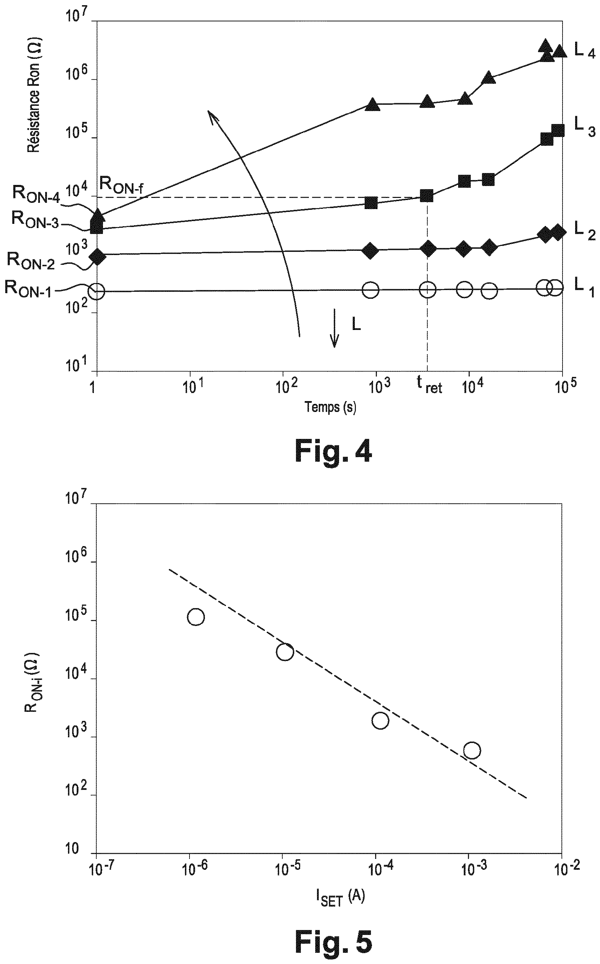

La figure 4 représente, de façon simplifiée, une série de courbes obtenue pour différentes largeurs $L_1$, $L_2$, $L_3$ et $L_4$ de filament. Rangées de bas en haut, les quatre courbes correspondent à une largeur L de filament décroissante ($L_1 > L_2 > L_3 > L_4$).

A chaque largeur de filament $L_1$, $L_2$, $L_3$ et $L_4$ correspond une valeur de la résistance initiale $R_{ON-i}$, soit l'ordonnée à l'origine de la courbe $R_{ON}(t)$. Ces ordonnées à l'origine sont notées respectivement $R_{ON-1}$, $R_{ON-2}$, $R_{ON-3}$ et $R_{ON-4}$ sur la figure 4 et peuvent être calculées, d'après la relation suivante :

$$(1) \qquad R_{ON-i} = \frac{\rho \cdot h}{L}$$

dans laquelle $\rho$ est la résistivité électrique du filament, h est la hauteur du filament (égale à e) et L sa largeur (égale à l'une des valeurs $L_1$ à $L_4$). Cette relation est dérivée de la loi d'Ohm, habituellement exprimée pour un objet en trois dimensions sous la forme :

$$R = \frac{\rho \cdot h}{S}$$

Pour simplifier l'analyse de rétention, et notamment réduire les temps de calcul, on considère ici seulement deux dimensions du filament, les dimensions h et L dans le plan des figures 1A et 1B. Ainsi, la surface S de la section du filament est ici remplacée par la largeur L du filament.

Comme les largeurs $L_1$, $L_2$, $L_3$ et $L_4$ diffèrent les unes des autres, les valeurs initiales $R_{ON-1}$, $R_{ON-2}$, $R_{ON-3}$ et $R_{ON-4}$ constituent différents points de départ pour les courbes de rétention.

En outre, les courbes de la figure 4 ont des pentes différentes, puisque la rétention augmente avec la diminution de la résistance initiale $R_{ON-i}$ (plus la résistance initiale $R_{ON-i}$ est faible, plus l'état « ON » est stable). Il en résulte que deux courbes de rétention ne peuvent se croiser.

La température à laquelle on effectue ces mesures de rétention peut être différente de la température de fonctionnement nominal de la cellule mémoire. Il peut notamment s'agir d'une température dite « d'accélération » bien supérieure à la température de fonctionnement. La température d'accélération est généralement comprise entre 70 °C et 300 °C, par exemple 200 °C. Elle permet d'accélérer la diffusion des atomes du filament, et donc la dégradation des états conducteur et isolant. C'est ainsi qu'on peut étudier la rétention d'une cellule mémoire en un temps très court (quelques jours).

L'étape F3 de la figure 3 consiste à déterminer, parmi les courbes de rétention $R_{ON}(t)$ simulées à l'étape F2, celle qui permet d'atteindre le seuil de résistance $R_{ON-f}$ au bout d'un temps de rétention t égal à la durée de rétention cible $t_{ret}$, autrement dit celle qui passe par le point de coordonnées $\{t_{ret}, R_{ON-i}\}$. Pour chaque analyse de rétention, il ne peut exister qu'une seule courbe qui satisfait à cette condition (puisque les courbes ne se chevauchent pas).

A l'étape F4, on détermine la résistance initiale $R_{ON-i}$ de la courbe sélectionnée à l'étape F3, par exemple en relevant simplement son ordonnée à l'origine. Dans l'exemple de la figure 4, la courbe passant par le seuil $R_{ON-f}$ après une durée $t_{ret}$ est la troisième courbe ayant pour ordonnée à l'origine la résistance $R_{ON-3}$.

Puis, en F5, on détermine le paramètre électrique de programmation de l'état « ON » qui permet d'obtenir cette résistance initiale. Ce paramètre est, de préférence, un courant électrique appliqué pendant l'écriture (ou phase de SET) de la mémoire : $I_{SET}$. Le courant d'écriture $I_{SET}$ détermine dans quelle mesure le filament conducteur est étroit ou large, ce qui a bien sûr une incidence sur sa résistance électrique.

La détermination de l'étape F5 est, de préférence, réalisée au moyen d'un abaque. Cet abaque représente la résistance initiale à l'état « ON » pour différentes valeurs du paramètre électrique de programmation.

La figure 5 donne un exemple d'abaque. Elle représente la résistance initiale $R_{ON-i}$ en fonction du courant d'écriture $I_{SET}$. Ce type d'abaque peut être construit, au préalable, en appliquant une rampe de courant à une cellule mémoire CBRAM de référence et en relevant, pour chaque valeur de la rampe de courant, la résistance du filament conducteur correspondante.

Dans un mode de mise en oeuvre des étapes F2 à F4, la simulation des courbes de rétention de l'état « ON » et la détermination de la résistance initiale $R_{ON-i}$ sont effectuées par dichotomie. Lors d'une première itération, la rétention d'un filament ayant une largeur L choisie arbitrairement est simulée. Si la résistance finale de ce filament, à $t=t_{ret}$, est supérieure à la résistance maximale attendue $R_{ON-f}$, alors la largeur du filament est augmentée pour l'itération suivante. Ceci aura pour effet d'abaisser la courbe de rétention, en choisissant une résistance initiale $R_{ON-i}$ plus faible. Si au contraire la résistance finale $R_{ON}(t_{ret})$ est inférieure à la valeur $R_{ON-f}$, alors la largeur du filament est diminuée pour l'itération suivante. Puis, on poursuit de cette façon par itérations successives jusqu'à ce que l'algorithme converge et qu'on obtienne la résistance initiale $R_{ON-i}$ (à t=0) correspondant au seuil $R_{ON-f}$ (à $t=t_{ret}$).

La largeur du filament est par exemple multipliée par deux d'une itération à l'autre, lorsque la résistance $R_{ON}(t_{ret})$ est trop importante. Lorsque la résistance $R_{ON}(t_{ret})$ est au contraire trop faible, la nouvelle largeur peut être égale à la moyenne des largeurs de deux itérations précédentes.

La détermination du paramètre de programmation de l'état « OFF » s'effectue de façon analogue aux étapes F2 à F5 décrites précédemment, à travers les étapes F6 à F9 suivantes :

- F6 : on simule des courbes de rétention de l'état « OFF » correspondant à différentes dimensions de filament, chaque courbe de rétention représentant maintenant la diminution de la résistance à l'état isolant $R_{OFF}$ en fonction du temps t ;
- F7 : on détermine, parmi l'ensemble des courbes de rétention $R_{OFF}(t)$, la courbe atteignant la valeur minimale $R_{OFF-f}$, après un temps de rétention t égal à la durée de rétention cible $t_{ret}$ (cette courbe étant unique pour les mêmes raisons qu'évoquées précédemment) ;
- F8 : on détermine la valeur initiale $R_{OFF-i}$ à partir de cette courbe de rétention, par exemple en relevant son ordonnée à l'origine ; et
- F9 : on détermine, de préférence au moyen d'un abaque, le paramètre de programmation de l'état « OFF » à partir de la valeur initiale $R_{OFF-i}$.

De préférence, les courbes de rétention de l'état « OFF » simulées à l'étape F6 correspondent à différentes hauteurs initiales h de filament résiduel. Le paramètre de programmation de l'état « OFF » est, par exemple, une tension d'effacement $V_{RST}$ appliquée aux bornes de la cellule mémoire, c'est-à-dire entre la cathode et l'anode.

La simulation des courbes de rétention de l'état « OFF » et la détermination de la résistance initiale $R_{OFF-i}$ (étapes F6 à F8) peuvent également être effectuées par dichotomie, via un algorithme similaire à celui décrit précédemment pour les étapes F2 à F4. D'une itération à l'autre, la hauteur h du filament résiduel sera diminuée lorsque la résistance finale de ce filament $R_{OFF}(t=t_{ret})$ est inférieure à la résistance minimale attendue $R_{OFF-f}$ et augmentée si au contraire la résistance $R_{OFF}(t_{ret})$ est supérieure à la valeur $R_{OFF-f}$.

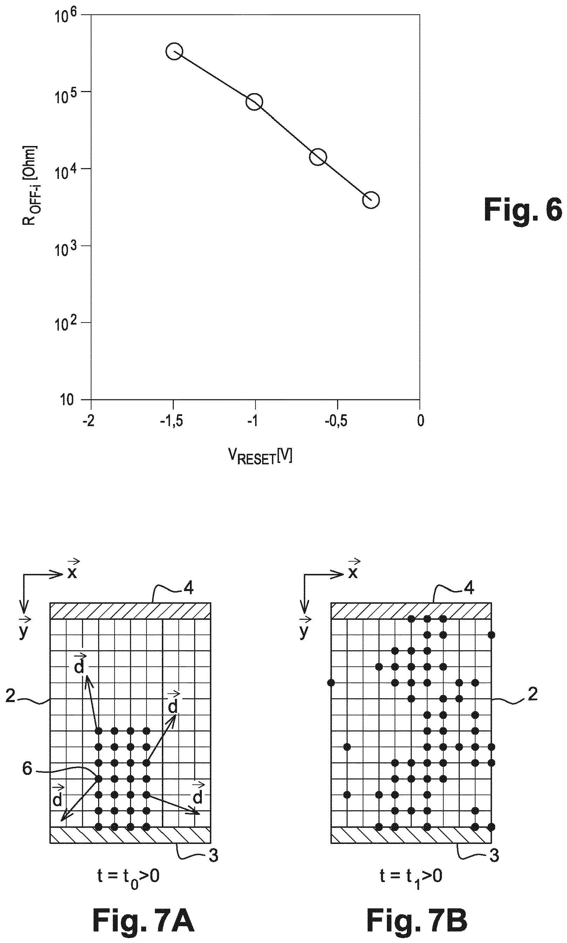

La figure 6 est un exemple d'abaque utilisé à l'étape F9. Cet abaque représente la fonction $R_{OFF-i}(V_{RST})$. De façon similaire à celui de la figure 5, il peut être établi en appliquant une rampe de tension $V_{SET}$ à une cellule mémoire CBRAM de référence et en relevant, pour chaque valeur de la rampe de tension, la résistance $R_{OFF-i}$ du filament résiduel correspondante.

Outre l'influence des conditions d'écriture sur la rétention de l'état « ON » et l'influence des conditions d'effacement sur la rétention de l'état « OFF », les inventeurs ont remarqué que ces mêmes conditions d'écriture influaient sur l'état effacé ultérieur. En d'autres termes, plus le courant $I_{SET}$ dans la phase de SET est important, plus l'état « OFF » suivant sera instable. Par conséquent, pour un courant $I_{SET}$ élevé, il faudra prévoir une tension de RESET $V_{RST}$ plus élevée qu'avec un courant $I_{SET}$ faible, afin de garantir la rétention de l'état « OFF ».

Pour cette raison, il est plus avantageux de déterminer d'abord le paramètre de programmation de l'état « ON » (étape F2 à F5), avant de déterminer le paramètre de programmation de l'état « OFF » (étape F6 à F9).

A l'issue de l'étape F3, on dispose de la courbe de résistance satisfaisant aux critères de rétention de l'état « ON » : $R_{ON-f}$ et $t_{ret}$. Comme chaque courbe simulée correspond une largeur particulière de filament, on peut déterminer, en même temps que la résistance initiale $R_{ON-i}$ à l'étape F4, la largeur de filament $L_{opt}$ correspondante. Comme les termes $L_{opt}$ et $R_{ON-i}$ sont liés par la relation (1) ci-dessus, on peut aussi les déduire l'un de l'autre dans une étape supplémentaire du procédé de détermination.

La largeur $L_{opt}$ est optimale car elle permet d'atteindre la rétention souhaitée, tout en minimisant la consommation électrique. On pourrait en effet prévoir une largeur de filament encore plus grande, mais le courant de SET pour l'obtenir serait d'autant plus important.

Après avoir déterminé la largeur de filament optimale $L_{opt}$, celle-ci est avantageusement utilisée dans l'analyse de rétention de l'état « OFF » effectuée à l'étape F6. En effet, cette largeur se retrouve au niveau du filament résiduel dans l'état effacé, car la tension d'effacement $V_{RST}$ ne joue que sur la hauteur h du filament résiduel. Les courbes de rétention de l'état « OFF » sont donc avantageusement simulées, à l'étape F6, pour un filament ayant une largeur initiale égale à la largeur optimale $L_{opt}$ et pour hauteur initiale h variable.

Ainsi, la valeur de $R_{OFF-i}$ déterminée à l'étape F8 correspond à une morphologie particulière du filament (largeur et hauteur résiduelle) induite à la fois par la résistance $R_{ON-i}$ (elle-même découlant du seuil $R_{ON-f}$) et par les attentes envers la rétention de l'état « OFF » (seuil $R_{OFF-f}$). Le procédé peut déterminer en plus de la largeur optimale $L_{opt}$ la hauteur résiduelle $h_{opt}$ de filament correspondant à la résistance $R_{OFF-i}$.

A l'issue du procédé de la figure 3, des conditions de programmation respectant à la fois la rétention de l'état « ON » (c'est-à-dire le seuil $R_{ON-f}$) et la rétention de l'état « OFF » ($R_{OFF-f}$) ont été déterminées. Ce résultat peut être obtenu systématiquement grâce au procédé selon l'invention, mais des facteurs autres que la rétention peuvent contraindre le choix des conditions de programmation, notamment des limitations technologiques ou la maîtrise de la consommation électrique.

Par exemple, la miniaturisation des électrodes ne permet pas toujours d'utiliser des largeurs de filament importantes. Il peut aussi être difficile d'effacer complétement le filament, sans risquer de détruire la cellule mémoire. Enfin, pour obtenir un filament large ayant une résistance $R_{ON}$ faible (et donc stable), il faut être en mesure d'appliquer un courant $I_{SET}$ élevé. Or, ce courant circule également pendant l'effacement de la cellule mémoire. Combiné à une tension d'effacement $V_{RST}$ forte, il provoque une consommation de puissance électrique importante. Enfin, conjointement à cette question de consommation électrique se pose le problème du dimensionnement des transistors d'accès permettant l'application de ces tensions et courants élevés.

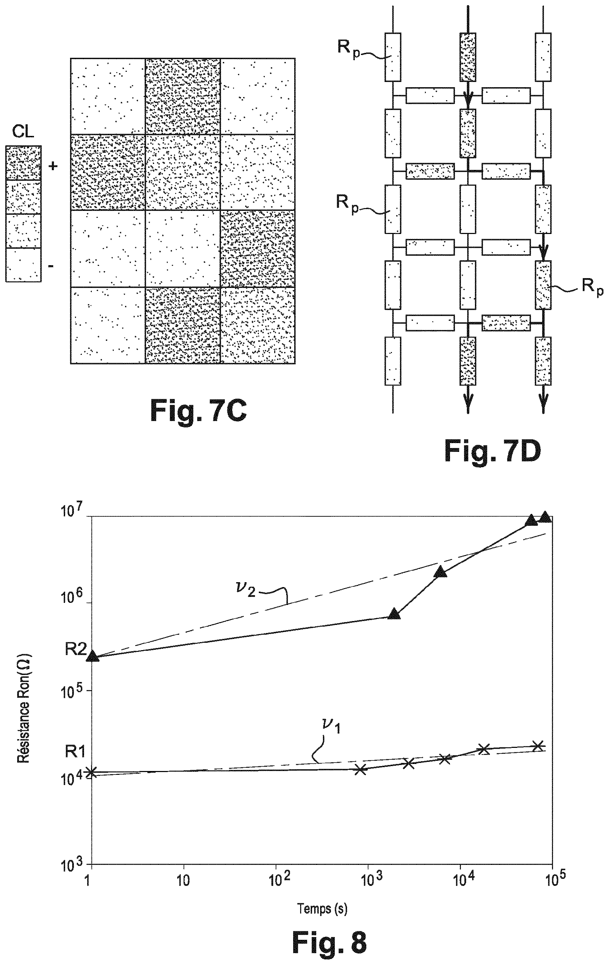

Les simulations et calculs du procédé de la figure 3 sont réalisés au moyen d'un calculateur programmé. Chaque courbe de rétention de l'état « ON » ou de l'état « OFF » peut être établie à l'aide d'un modèle mis en oeuvre par ordinateur. Un modèle numérique préférentiel est décrit ci-dessous, en relation avec les figures 7A à 7D. Il peut être décomposé en quatre étapes.

La première étape simule, à l'aide d'un modèle de diffusion, le déplacement des atomes constituant le filament entre deux instants $t_0$ et $t_1$ (figures 7A et 7B respectivement). Dans ce modèle de diffusion, les atomes du filament sont gérés individuellement et la couche d'électrolyte est assimilée à une matrice.

Chaque atome est d'abord placé dans la matrice, afin de recréer la forme initiale du filament : un filament entier dans l'état conducteur « ON » ou un filament tronqué dans l'état isolant « OFF », selon la courbe de rétention à obtenir.

La figure 7A représente un électrolyte 2 sous forme matricielle (situé entre les électrodes 3 et 4) comprenant, à titre d'exemple, un filament résiduel 6 dans son état initial ($t = t_0 = 0$). La distance interatomique, c'est-à-dire la distance séparant deux atomes consécutifs, peut être fixée à 0,2 nm quelle que soit la technologie de la mémoire, afin de simplifier le modèle.

Alternativement, la distance interatomique peut être variable selon la nature du matériau qui compose le filament, par exemple du cuivre ou de l'argent dans le cas d'un métal. Dans ce cas, elle vaut de préférence deux fois le rayon de covalence de l'élément. Le modèle sera plus précis, car adapté à la nature du filament.

Pour le placement des atomes dans la matrice, la composition du filament peut être considérée comme planaire, c'est-à-dire que le nombre d'atomes au centre du filament est identique au nombre d'atomes sur les bords. Ce choix permet d'obtenir de bons résultats, sans étendre le temps de calcul. La composition peut aussi être choisie « pseudo-cylindrique ». Ce choix permet de simuler le comportement d'un filament cylindrique, en considérant que le nombre d'atomes au centre du filament rectangulaire (simulations en 2 dimensions) est supérieure au nombre d'atomes sur les bords. La composition « pseudo-cylindrique » a pour avantage de donner des résultats plus précis dans le cas d'un filament cylindrique, notamment pour les grands diamètres (L>3 nm), mais demande un temps de calcul supérieur.

Le placement des atomes du filament résiduel initial peut ne pas être aussi simplifié que celui représenté sur la figura 7A. Par exemple, on peut prévoir dans la matrice une concentration d'atomes résiduelle au-dessus du filament 6. Il en est de même d'un filament entier dans l'état « ON » initial, la concentration d'atomes pouvant varier d'un endroit à l'autre du filament.

Après avoir représenté le filament dans la matrice, un vecteur de diffusion thermique $\vec{d}$ est appliqué à chaque atome, ce qui aura pour effet de le déplacer dans la matrice. De préférence, ce déplacement est aléatoire et échantillonné à chaque seconde.

Le vecteur de diffusion $\vec{d}$ possède deux composantes $\vec{d_x}$ et $\vec{dy}$ dans le plan de coupe de la figure 7A. Pour une diffusion « aléatoire », les deux composantes $\vec{d_x}$ et $\vec{dy}$ s'écrivent :

$$\vec{d_x} = \sqrt{2D}.\,Rand\,(\vec{x})$$

$$\vec{d_y} = \sqrt{2D}.\,Rand\,(\vec{y})$$

$\vec{d_x}$ et $\vec{d_x}$ sont les vecteurs de diffusion selon les directions $\vec{x}$ et $\vec{y}$ de la figure 7A, *Rand* est une fonction de génération de nombres aléatoires, d'après une loi de distribution normale, et D est le coefficient de diffusion.

Le coefficient de diffusion D suit une loi d'Arrhenius :

$$D = D_0.\,exp\,\left(-\frac{E_A}{kT}\right)$$

où $D_0$ est le facteur pré-exponentiel de diffusivité, $E_A$ est l'énergie d'activation, k est la constante de Boltzmann (k = $1,381.10^{-23}$ J.K$^{-1}$) et T désigne la température de mesure (à laquelle on simule la dissolution du filament).

En appliquant le vecteur de diffusion $\vec{d}$, le modèle peut situer à chaque instant les atomes au sein de la matrice de l'électrolyte 2. La figure 7B représente à titre d'exemple la répartition des atomes au sein de la matrice après un temps $t_1$ supérieur à $t_0$ ($t_1 > 0$).

Pendant la deuxième étape, le modèle procède au calcul des concentrations locales $C_L$ en atomes métalliques dans les différentes zones de la couche d'électrolyte 2. Pour ce faire, l'électrolyte 2 est à nouveau découpé pour former un maillage, une maille représentant par exemple une surface de 0,01 nm$^2$ et pouvant contenir plusieurs atomes, puis on compte les atomes dans chaque maille. La figure 7C illustre, par différents degrés de remplissage, la concentration d'atomes $C_L$ obtenue d'après la matrice de l'électrolyte à l'instant $t_1$ (figure 7B).

La concentration d'atomes (nombre par unité de surface) d'une maille est avantageusement moyennée avec les concentrations d'atomes des mailles voisines (par exemple, sur une distance de 5 mailles), afin de prendre en compte l'influence des atomes voisins sur la conduction électrique.

A partir de la concentration locale en atomes $C_L$, on peut calculer, lors d'une troisième étape, la résistivité électrique $\rho_L$ dans chaque maille. Ce calcul s'effectue à l'aide d'un modèle de conduction électrique, tel que la relation suivante :

$$\rho_L = \frac{1}{q.\,\mu.\,C_L}$$

$\mu$ étant la mobilité des porteurs de charge électrique et q la charge élémentaire (q = $1,6.10^{19}$ cm$^{-3}$).

Enfin, lors de la quatrième étape représentée à la figure 4D, une résistance globale $R_{OFF}$ (ou $R_{ON}$ pour l'étude de l'état « ON ») de la mémoire est calculée à partir des résistivités électriques locales $\rho_L$ dans les différentes mailles de la couche d'électrolyte.

Cela peut être réalisé en calculant au préalable des résistances de passage $R_P$ entre deux mailles adjacentes, et ce pour chaque paire de mailles. Chaque résistance de passage $R_P$ peut être dérivée des résistivités locales $\rho_L$ des deux mailles adjacentes et de la distance séparant le centre de ces mailles (ici 0.2 nm). Les résistances de passage $R_P$ sont interconnectées et forment un réseau dont la résistance équivalente est égale à la résistance $R_{OFF}(t_1)$.

Pour obtenir une courbe de rétention, ces quatre étapes sont mises en oeuvre pour plusieurs durées de rétention t, de sorte qu'on obtienne plusieurs valeurs de résistance globale $R_{OFF}$ échelonnées dans le temps.

Le modèle numérique ci-dessus fait intervenir la mobilité $\mu$ des porteurs de charges et le coefficient de diffusion D. Ces paramètres $\mu$ et D dépendent de la technologie de CBRAM utilisée et peuvent ne pas être connus. Une technique permettant de les déterminer est donc proposée.

Pour déterminer le coefficient D, une étude de rétention de l'état écrit est menée à une première température T1, pour deux valeurs initiales de résistance $R_{ON\text{-}i}$ (i.e. deux largeurs de filaments), R1 et R2. Cette étude expérimentale permet d'obtenir deux valeurs du coefficient de rétention, représenté par la pente de chaque courbe. La figure 8 représente à titre d'exemple deux courbes de rétention de l'état « ON » obtenues à la température T1 de 130°C et ayant pour résistances initiales R1 = 1,2.10$^4$ Ω et R2 = 2,3.10$^5$ Ω. v1 et v2 sont les coefficients de rétention associés aux deux courbes de résistance. Ils ont été obtenus par régression linéaire et valent respectivement : v1 = 5.10$^{-2}$ Ω.s$^{-1}$ et v2 = 3,5.10$^{-1}$ Ω.s$^{-1}$.

Grâce à la relation (1) liant la résistance initiale $R_{ON\text{-}i}$ à la largeur L du filament, on détermine le rapport des largeurs L1 et L2 correspondant aux résistances R1 et R2 :

$$R1 = \frac{\rho \cdot h}{L1} = 1,2.\,10^4 \ \Omega$$

$$R2 = \frac{\rho \cdot h}{L2} = 2,3.\,10^5 \ \Omega$$

d'où :

$$\frac{L2}{L1} = \frac{R1}{R2} = 0.05$$

soit :

$$(2) \qquad \frac{1}{L2} = 20.\frac{1}{L1}$$

Ensuite, un graphique représentant le coefficient de rétention v en fonction du coefficient de diffusion thermique D et de l'inverse de la largeur 1/L est réalisé. Ce graphique est, de préférence, obtenu en utilisant le même modèle numérique que décrit précédemment, sauf à fixer dans ce modèle une valeur arbitraire de la mobilité (car la « vraie » valeur reste encore à déterminer). Le modèle simule ainsi une multitude de courbes de rétention à la température T1, en faisant varier la largeur L du filament et le paramètre D, puis calcule les pentes correspondantes.

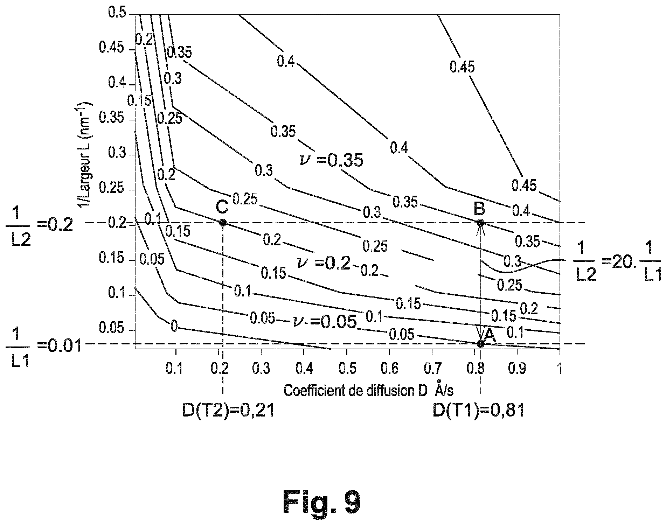

La figure 9 représente un tel graphique, sous la forme d'un ensemble de courbes iso-pente. Chaque courbe iso-pente représente l'ensemble des combinaisons de valeurs {D, 1/L} ayant pour coefficient de rétention la valeur indiquée sur la courbe. Le coefficient de diffusion thermique D, en abscisses, varie de 0 à 1 Å.s$^{-1}$, et l'inverse de la largeur L, en ordonnées, varie de 0 à 0,5 nm$^{-1}$.

Grâce à l'analyse de rétention menée à la température T1, on dispose de deux valeurs v1 et v2 de coefficient de rétention et d'une relation (2) liant les largeurs de filament L1 à L2. Alors, sur le graphique de la figure 9, on cherche les points A et B appartenant respectivement aux courbes iso-pente v1 = 5.10$^{-2}$ Ω.s$^{-1}$ et v2 = 5.10$^{-2}$ Ω.s$^{-1}$ et dont les ordonnées respectives 1/L1 et 1/L2 vérifient la relation (2). Le coefficient de diffusion thermique D, à la température T1, est alors donné par l'abscisse des points A et B. Dans cet exemple, D(T1) vaut 0,81 Å.s$^{-1}$.

Les points A et B ont la même abscisse D, car ils correspondent à la même température T1 et donc au même coefficient de diffusion (l'énergie d'activation $E_A$ étant supposée constante). Le graphique des courbes iso-pente permet ainsi de déterminer une première valeur du coefficient de diffusion D(T1), à l'aide de deux courbes de rétention $R_{ON}(t)$ simulées à la même température T1, et plus particulièrement à partir des ordonnées à l'origine et des pentes de ces deux courbes.

Le choix d'une valeur arbitraire de mobilité μ pour établir les courbes iso-pente n'est pas préjudiciable car, en calculant le rapport des largeurs L1 et L2 et en le reportant sur le graphique de la figure 9, on s'affranchit justement de cette mobilité.

Afin de déterminer le paramètre D pour n'importe quelle température, et pas seulement à la température T1, une seconde étude de rétention en température est réalisée. Dans cette seconde étude, on observe le comportement d'un état « ON » identique à l'un des deux états « ON » précédents, c'est-à-dire le comportement d'un filament ayant une résistance initiale égale à R1 ou R2, mais à une seconde température T2 différente de T1. Ainsi, contrairement à l'analyse précédente, la résistance est fixe et la température est variable. On obtiendra alors, pour le même filament, une seconde valeur du coefficient de rétention (à la nouvelle température T2).

A titre d'exemple, le filament choisi est celui ayant une largeur L2 (et donc une résistance initiale R2). La courbe de rétention relevée à la température T2 de 75 °C possède une pente v1' valant $2,0.10^{-1}$ $\Omega.s^{-1}$.

Sur le graphique de la figure 9, on peut dès lors faire apparaitre un troisième point C ayant la même ordonnée que le point B et situé sur la courbe iso-pente v1' = $2.10^{-2}$ $\Omega.s^{-1}$. L'abscisse du point C correspond à la valeur du coefficient de diffusion D à la température T2. Cela donne ici : $D(T2)$ = 0,21 $Å.s^{-1}$.

A partir des valeurs $D(T1)$ et $D(T2)$, il est possible d'extraire l'énergie d'activation $E_A$ et le facteur pré-exponentiel $D_0$ contenus dans la relation du coefficient de diffusion D. Il suffit pour cela de résoudre le système d'équations suivant :

$$D(T1) = D_0.\exp\left(-\frac{E_A}{kT1}\right)$$

$$D(T2) = D_0.exp\left(-\frac{E_A}{kT2}\right)$$

Le coefficient D est alors déterminé pour une température T quelconque, en remplaçant $E_A$ et $D_0$ par leurs valeurs respectives, 0,28 eV et 2550 $Å.s^{-1}$ :

$$D(T) = 2550.exp\left(-\frac{0,28}{kT}\right)$$

Enfin, pour déterminer la valeur de mobilité $\mu$, on résout un autre système d'équations basées sur la loi d'Ohm, connaissant les résistances R1, R2 et les largeurs correspondantes L1, L2 :

$$R1 = \frac{\rho \cdot h}{L1} = \frac{1}{\mu.n.q}\frac{h}{L1}$$

$$R2 = \frac{\rho \cdot h}{L2} = \frac{1}{\mu.n.q}\frac{h}{L2}$$

n étant la concentration (inconnue) en porteurs de charge.

Dans l'exemple de la figure 9, L1 vaut 100 nm et L2 vaut 5 nm pour respectivement R1 = $1,2.10^4$ $\Omega$ et R2 = $2,3.10^5$ $\Omega$. La mobilité $\mu$ est alors égale à $1,8.10^{13}$ $V^{-1}s^{-1}$.

**Revendications**

1.   Procédé de détermination de paramètres électriques servant à programmer une mémoire vive résistive dans un état isolant (OFF) et dans un état conducteur (ON), ladite mémoire comprenant des première et seconde électrodes (3, 4) séparées par une couche en matériau électriquement isolant (2), et passant de l'état isolant (OFF) à l'état conducteur (ON) par formation d'un filament conducteur (6) entre les première et seconde électrodes (3, 4), procédé comprenant les étapes suivantes :

   - fournir un jeu de paramètres comprenant une durée de rétention cible ($t_{ret}$) des états isolant (OFF) et conducteur (ON), une valeur maximale ($R_{ON-f}$) de résistance à l'état conducteur et une valeur minimale ($R_{OFF-f}$) de résistance à l'état isolant ;
   - simuler des courbes de rétention de l'état conducteur (ON) correspondant à différentes dimensions de filament (6), chaque courbe de rétention de l'état conducteur représentant l'augmentation de la résistance à l'état conducteur ($R_{ON}$) en fonction d'un temps de rétention (t) ;
   - déterminer la courbe de rétention de l'état conducteur atteignant la valeur maximale ($R_{ON-f}$) de résistance à l'état conducteur après un temps de rétention (t) égal à la durée de rétention cible ($t_{ret}$) ;
   - déterminer une valeur initiale ($R_{ON-i}$) de résistance à l'état conducteur à partir de ladite courbe de rétention de l'état conducteur ;
   - déterminer le paramètre de programmation ($I_{SET}$) de l'état conducteur (ON) à partir de la valeur initiale ($R_{ON-i}$)

de résistance à l'état conducteur ;

- simuler des courbes de rétention de l'état isolant correspondant à différentes dimensions de filament (6), chaque courbe de rétention de l'état isolant représentant la diminution de la résistance à l'état isolant ($R_{OFF}$) en fonction du temps de rétention (t) ;

- déterminer la courbe de rétention de l'état isolant atteignant la valeur minimale ($R_{OFF-f}$) de résistance à l'état isolant après un temps de rétention (t) égal à la durée de rétention cible ($t_{ret}$) ;

- déterminer une valeur initiale ($R_{OFF-i}$) de résistance à l'état isolant (OFF) à partir de ladite courbe de rétention de l'état isolant ;

- déterminer le paramètre de programmation ($V_{RST}$) de l'état isolant à partir de la valeur initiale ($R_{OFF-i}$) de résistance à l'état isolant.

2. Procédé selon la revendication 1, dans lequel la valeur initiale ($R_{ON-i}$) de résistance à l'état conducteur (ON) est obtenue en relevant l'ordonnée à l'origine de ladite courbe de rétention de l'état conducteur et dans lequel la valeur initiale ($R_{OFF-i}$) de résistance à l'état isolant (OFF) est obtenue en relevant l'ordonnée à l'origine de ladite courbe de rétention de l'état isolant.

3. Procédé selon l'une des revendications 1 et 2, dans lequel les courbes de rétention de l'état conducteur (ON) correspondent à différentes largeurs initiales (L) de filament (6), le filament ayant une hauteur initiale (h) égale à l'épaisseur (e) de la couche en matériau électriquement isolant (2).

4. Procédé selon la revendication 3, comprenant une étape de détermination d'une largeur de filament optimale ($L_{opt}$) correspondant à ladite courbe de rétention de l'état conducteur (ON).

5. Procédé selon la revendication 4, dans lequel les courbes de rétention de l'état isolant (OFF) sont simulées pour un filament (6) ayant une largeur initiale (L) égale à la largeur optimale ($L_{opt}$) et une hauteur initiale (h) variable.

6. Procédé selon l'une quelconque des revendications 1 à 5, dans lequel la première électrode (3) est en un matériau inerte, la deuxième électrode (4) est en un matériau soluble et le matériau électriquement isolant est un matériau conducteur ionique, le filament conducteur (6) étant formé par des atomes du matériau de l'électrode soluble (4).

7. Procédé selon la revendication 6, dans lequel les courbes de rétention de l'état conducteur (ON) et de l'état isolant (OFF) sont obtenues en effectuant, pour différents temps de rétention (t), les étapes suivantes :

- simuler une diffusion des atomes formant le filament (6) ;
- calculer la concentration en atomes ($C_L$) dans différentes portions de la couche en matériau électriquement isolant (2) ;
- calculer, à partir de la concentration en atomes ($C_L$), la résistivité électrique équivalente ($\rho_L$) dans chaque portion ; et
- calculer une résistance globale ($R_{ON}$, $R_{OFF}$) de la mémoire à partir des résistivités électriques équivalentes des différentes portions de la couche en matériau électriquement isolant (2).

8. Programme d'ordinateur comportant des instructions mettant en oeuvre un procédé selon l'une quelconque des revendications 1 à 7, lorsque ce programme est exécuté par un ordinateur.

**Patentansprüche**

1. Bestimmungsverfahren von elektrischen Parametern, die zur Programmierung eines ohmschen Arbeitsspeichers in einem isolierenden Zustand (OFF) und in einem leitenden Zustand (ON) dienen, wobei der genannte Speicher erste und zweite Elektroden (3, 4) umfasst, die durch eine Schicht aus elektrisch isolierendem Material (2) getrennt sind, und vom isolierenden Zustand (OFF) in den leitenden Zustand (ON) per Bildung eines leitenden Glühdrahts (6) zwischen den ersten und zweiten Elektroden (3, 4) übergeht, wobei das Verfahren die folgenden Schritte umfasst:

- Liefern eines Parametersatzes, der eine Zielrückhaltedauer ($t_{ret}$) der isolierenden (OFF) und leitenden (ON) Zustände, einen maximalen Widerstandswert ($R_{ON-f}$) im leitenden Zustand und einen minimalen Widerstandswert ($R_{OFF-f}$) im isolierenden Zustand umfasst;
- Simulieren der Rückhaltekurven des leitenden Zustandes (ON), der unterschiedlichen Abmessungen des Glühdrahtes (6) entspricht, wobei jede Rückhaltekurve des leitenden Zustandes die Erhöhung des Widerstandes im leitenden Zustand ($R_{ON}$) in Abhängigkeit von einer Rückhaltezeit (t) darstellt;

- Bestimmen der Rückhaltekurve des leitenden Zustandes, der den maximalen Rückhaltewert ($R_{ON-f}$) im leitenden Zustand nach einer Rückhaltezeit (t) erreicht, die gleich der Zielrückhaltedauer ($t_{ret}$) ist;
- Bestimmen eines Widerstandsanfangswertes ($R_{ON-i}$) im leitenden Zustand ausgehend von der genannten Rückhaltekurve des leitenden Zustandes;
- Bestimmen des Programmierparameters ($I_{SET}$) des leitenden Zustandes (ON) ausgehend von dem Widerstandsanfangswert ($R_{ON-i}$) im leitenden Zustand;
- Simulieren der Rückhaltekurven des isolierenden Zustandes, der unterschiedlichen Abmessungen des Glühdrahtes (6) entspricht, wobei jede Rückhaltekurve des isolierenden Zustandes die Abnahme des Widerstandes im isolierenden Zustand ($R_{OFF}$) in Abhängigkeit von der Rückhaltezeit (t) darstellt;
- Bestimmen der Rückhaltekurve des isolierenden Zustandes, der den minimalen Widerstandswert ($R_{OFF-f}$) im isolierenden Zustand nach einer Rückhaltezeit (t) erreicht, die gleich der Zielrückhaltedauer ($t_{ret}$) ist;
- Bestimmen eines Widerstandsanfangswertes ($R_{OFF-i}$) im isolierenden Zustand (OFF) ausgehend von der genannten Rückhaltekurve des isolierenden Zustandes;
- Bestimmen des Programmierparameters ($V_{RST}$) des isolierenden Zustandes ausgehend von dem Widerstandsanfangswert ($R_{OFF-i}$) im isolierenden Zustand.

2. Verfahren gemäß Anspruch 1, bei dem der Widerstandsanfangswert ($R_{ON-i}$) im leitenden Zustand (ON) durch Ablesen der Ordinate erhalten wird, die der Ursprung der genannten Rückhaltekurve des leitenden Zustandes ist und in dem der Widerstandsanfangswert ($R_{OFF-i}$) im isolierenden Zustand (OFF) durch Ablesen der Ordinate erhalten wird, die der Ursprung der genannten Rückhaltekurve des isolierenden Zustands ist.

3. Verfahren gemäß einem der Ansprüche 1 und 2, bei dem die genannten Rückhaltekurven des leitenden Zustandes (ON) unterschiedlichen Anfangsbreiten (L) des Glühdrahtes (6) entsprechen, wobei der Glühdraht eine Anfangshöhe (h) gleich der Dicke (e) der elektrisch isolierenden Materialschicht (2) hat.

4. Verfahren gemäß Anspruch 3, umfassend einen Bestimmungsschritt einer optimalen Breite ($L_{opt}$) des Glühdrahtes, die der genannten Rückhaltekurve des leitenden Zustandes (ON) entspricht.

5. Verfahren gemäß Anspruch 4, bei dem die Rückhaltekurven des isolierenden Zustandes (OFF) für einen Glühdraht (6) simuliert sind, der eine Anfangsbreite (L) gleich der optimalen Breite ($L_{opt}$) und eine variable Anfangshöhe (h) hat.

6. Verfahren gemäß irgendeinem der Ansprüche 1 bis 5, bei dem die genannte erste Elektrode (3) aus einem inerten Material ist, die zweite Elektrode (4) aus einem löslichen Material ist und das elektrisch isolierende Material ein ionisches leitendes Material ist, wobei der leitende Glühdraht (6) durch Atome des Materials der löslichen Elektrode (4) geformt ist.

7. Verfahren gemäß Anspruch 6, bei dem die Rückhaltekurven des leitenden Zustandes (ON) und des isolierenden Zustandes (OFF) für unterschiedliche Rückhaltezeiten (t) per Durchführung der folgenden Schritte erhalten werden:

- Simulieren einer Diffusion der den Glühdraht (6) formenden Atome;
- Berechnen der Konzentration an Atomen ($C_L$) in unterschiedlichen Abschnitten der Schicht aus elektrisch isolierendem Material (2);
- ausgehend von der Konzentration an Atomen ($C_L$) Berechnen der äquivalenten elektrischen Resistivität ($p_L$) in jedem Abschnitt; und
- Berechnen eines globalen Widerstandes ($R_{ON}$, $R_{OFF}$) des Speichers ausgehend von den äquivalenten elektrischen Resistivitäten der unterschiedlichen Abschnitte der Schicht aus elektrisch isolierendem Material (2).

8. Computerprogramm, das Anweisungen umfasst, die ein Verfahren gemäß irgendeinem der Ansprüche 1 bis 7 umsetzt, wenn dieses Programm durch einen Computer ausgeführt wird.

**Claims**

1. Method for determining electrical parameters used to program a resistive random access memory in an insulating state (OFF) and in a conducting state (ON), said memory comprising first and second electrodes (3, 4) separated by a layer made of an electrically insulating material (2), and passing from the insulating state (OFF) to the conducting state (ON) by formation of a conducting filament (6) between the first and second electrodes (3, 4), method comprising the following steps:

- providing a set of parameters including a target retention time ($t_{ret}$) of the insulating (OFF) and conducting (ON) states, a maximum resistance value ($R_{ON-f}$) in the conducting state and a minimum resistance value ($R_{OFF-f}$) in the insulating state;
- simulating retention curves of the conducting state (ON) corresponding to different dimensions of the filament (6), each retention curve of the conducting state representing the increase of the resistance in the conducting state ($R_{ON}$) as a function of a retaining time (t);
- determining the retention curve of the conducting state reaching the maximum resistance value ($R_{ON-f}$) in the conducting state after a retention time (t) equal to the target retention time ($t_{ret}$);
- determining an initial resistance value ($R_{ON-i}$) in the conducting state from said retention curve of the conducting state;
- determining the programming parameter ($I_{SET}$) of the conducting state (ON) from the initial resistance value ($R_{ON-i}$) in the conducting state;
- simulating retention curves of the insulating state corresponding to different dimensions of the filament (6), each retention curve of the insulating state representing the decrease of the resistance in the insulating state ($R_{OFF}$) as a function of the retention time (t);
- determining the retention curve of the insulating state reaching the minimum resistance value ($R_{OFF-f}$) in the insulating state after a retention time (t) equal to the target retention time ($t_{ret}$);
- determining an initial resistance value ($R_{OFF-i}$) in the insulating state (OFF) from said retention curve of the insulating state;
- determining the programming parameter ($V_{RST}$) of the insulating state from the initial resistance value ($R_{OFF-i}$) in the insulating state.

2. Method according to claim 1, wherein the initial resistance value ($R_{ON-i}$) in the conducting state (ON) is obtained by determining the Y-intercept of said retention curve of the conducting state and wherein the initial resistance value ($R_{OFF-i}$) in the insulating state (OFF) is obtained by determining the Y-intercept of said retention curve of the insulating state.

3. Method according to one of claims 1 and 2, wherein the retention curves of the conducting state (ON) correspond to different initial widths (L) of filament (6), the filament having an initial height (h) equal to the thickness (e) of the layer made of electrically insulating material (2).

4. Method according to claim 3, comprising a step of determining an optimal filament width ($L_{opt}$) corresponding to said retention curve of the conducting state (ON).

5. Method according to claim 4, wherein the retention curves of the insulating state (OFF) are simulated for a filament (6) that has an initial width (L) equal to the optimal width ($L_{opt}$) and an variable initial height (h).

6. Method according to any of claims 1 to 5, wherein the first electrode (3) is made of an inert material, the second electrode (4) is made of a soluble material and the electrically insulating material is an ionic conductive material, the conducting filament (6) being formed by atoms of the material of the soluble electrode (4).

7. Method according to claim 6, wherein the retention curves of the conducting state (ON) and of the insulating state (OFF) are obtained by carrying out, for different retention times (t), the following steps:

- simulating a diffusion of the atoms forming the filament (6);
- calculating the concentration of atoms ($C_L$) in different portions of the layer made of electrically insulating material (2);
- calculating, from the concentration of atoms ($C_L$), the equivalent electrical resistivity ($\rho_L$) in each portion; and
- calculating an overall resistance ($R_{ON}$, $R_{OFF}$) of the memory from the equivalent electrical resistivities of the different portions of the layer made of electrically insulating material (2).

8. Computer program comprising instructions implementing a method according to any of claims 1 to 7, when this program is executed by a computer.

Etat <<OFF>>

**Fig. 1A**

Etat <<ON>>

**Fig. 1B**

**Fig. 2**

Spécifier la durée de rétention cible $t_{ret}$ et les seuils de résistance $R_{ON\text{-}f}$ et $R_{OFF\text{-}f}$ — F1

Simuler des courbes de rétention $R_{ON(t)}$ pour différentes dimensions de filament — F2

Déterminer la courbe de rétention $R_{ON(t)}$ atteignant le seuil $R_{ON\text{-}f}$ à t=$t_{ret}$ — F3

Déterminer la valeur initiale de rétention $R_{ON(t)}$ de cette courbe de rétention — F4

Déterminer le paramètre de programmation de l'état <<ON>> à partir de $R_{ON\text{-}i}$ — F5

Simuler des courbes de rétention $R_{OFF(t)}$ pour différentes dimensions de filament — F6

Déterminer la courbe de rétention $R_{OFF(t)}$ atteignant le seuil $R_{OFF\text{-}f}$ à t=$t_{ret}$ — F7

Déterminer la valeur initiale de rétention $R_{OFF\text{-}i}$ de cette courbe de rétention — F8

Déterminer le paramètre de programmation de l'état <<OFF>> à partir de $R_{OFF\text{-}i}$ — F9

**Fig. 3**

**Fig. 4**

**Fig. 5**

Fig. 6

Fig. 7A

Fig. 7B

**Fig. 7C**

**Fig. 7D**

Fig. 8

**Fig. 9**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2012201069 A

- US 2005243633 A

**Littérature non-brevet citée dans la description**

- **E. VIANELLO et al.** Solid-State Device Research Conference (ESSDERC). *Proceedings of the European,* 2012, 278-281